# FASCICULE DE BREVET EUROPEEN

(11) **EP 1 244 070 B1**
(45) Date de publication et mention de la délivrance du brevet: **21.06.2006**
(21) Numéro de dépôt: 02005850.9
(22) Date de dépôt: 14.03.2002
(51) Int. Cl.: G07C 9/00, H03B 5/12

(54) **Dispositif d'émission d'informations d'un véhicule vers un object portatif**
Vorrichtung zur Informationsübertragung von einem Fahrzeug zu einem tragbaren Gegenstand
Device for transmitting information from a vehicle to a portable object

(30) Priorité: 20.03.2001 FR 0103741
(43) Date de publication de la demande: 25.09.2002
(73) Titulaire: VALEO SECURITE HABITACLE S.A.S., 94042 Créteil Cédex (FR)
(72) Inventeur: Rydel, M. Charles, 75012 Paris (FR)
(74) Mandataire: Rosolen-Delarue, Katell

(56) Documents cités:
- FR-A- 1 581 456
- FR-A- 2 248 761
- US-A- 3 072 862
- US-A- 4 355 404
- US-A- 4 584 587
- US-A- 4 593 256
- US-A- 5 699 021
- US-A- 5 983 084

## Description

L'invention est relative à un dispositif d'émission d'informations d'un véhicule automobile vers un objet portatif à proximité.

Elle concerne plus particulièrement, mais non exclusivement, un tel dispositif d'émission qui est destiné à fournir un signal d'activation à un élément portatif pour que ce dernier émette un signal d'identification. Si ce signal correspond au véhicule concerné, le déverrouillage des portières est commandé et, éventuellement, les circuits du véhicule sont mis sous tension sans que l'utilisateur ait à introduire une clé dans une portière ou à faire intervenir une clé de contact au tableau de bord.

L'objet portatif est, par exemple, un badge du type carte de crédit que le possesseur du véhicule garde en permanence sur lui et c'est la seule présence de ce badge à proximité du véhicule qui permet d'en donner l'accès et de faire démarrer le véhicule sans que le possesseur ait à intervenir.

Un tel dispositif d'émission est alimenté par une batterie d'accumulateurs dans le véhicule. Il est donc préférable que sa consommation en énergie électrique soit minimale.

En outre, comme il s'agit de dispositifs fabriqués en grande série, il est également préférable que son coût soit minimisé.

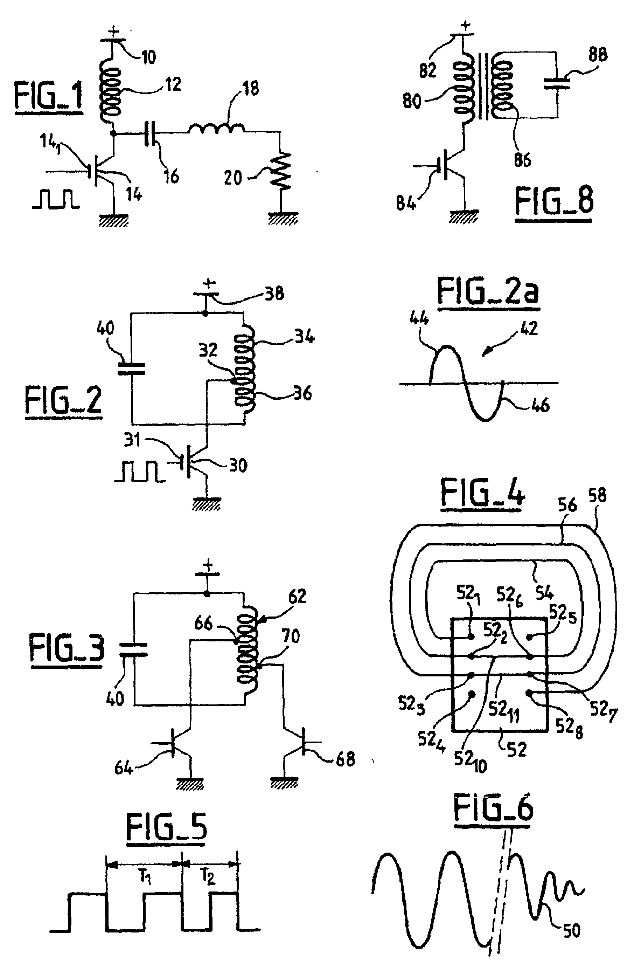

La figure 1 représente un dispositif d'émission connu à bord d'un véhicule.

Ce dispositif comporte, entre une borne 10, sur laquelle est appliqué le pôle positif d'une batterie du véhicule, et la masse, une inductance 12 et un transistor MOS 14. Le point commun au transistor 14 et à l'inductance 12 est relié à la masse par l'intermédiaire d'un condensateur 16, d'une bobine ou antenne 18 d'émission, et d'une résistance 20.

Sur l'électrode de commande 14₁ du transistor 14, sont appliqués des signaux carrés qui rendent le transistor alternativement bloqué et conducteur.

Lorsque le transistor est conducteur, l'inductance 12 accumule de l'énergie qu'elle restitue à l'antenne 18 lorsque ce transistor est bloqué.

Les signaux appliqués sur l'électrode 14₁ du transistor 14 peuvent être modulés de deux manières différentes. Dans la première manière, les créneaux appliqués sur l'électrode 14₁ ont une fréquence constante mais une émission sur plusieurs périodes correspond, par exemple, à un "1" tandis qu'une absence d'émission correspond à un "0". Une telle commande par tout ou rien est quelquefois dénommée modulation d'amplitude. Elle peut être utilisée pour émettre un signal de réveil du badge se trouvant à proximité.

Les signaux de commande du transistor peuvent être aussi modulés en fréquence, c'est-à-dire que les informations à transmettre par l'antenne 18 sont représentées par la fréquence des signaux carrés appliqués sur l'électrode de commande du transistor 14.

On a constaté qu'un tel dispositif d'émission présente une vitesse de transmission de données qui est limitée et que cette limitation de vitesse de transmission a l'origine suivante :

En régime établi, c'est-à-dire pour une fréquence constante de créneaux, les signaux émis par l'antenne 18 ont une amplitude constante. Par contre, lors d'un changement de fréquence des créneaux, afin de transmettre une information, il se produit une diminution temporaire d'amplitude et cette diminution est d'autant plus importante que le décalage de la fréquence transmise est élevé. À partir d'une vitesse de transmission limite, la modulation d'amplitude empêche une transmission correcte des signaux.

En outre, lors d'une transmission par tout ou rien, au début de l'application de créneaux sur l'électrode 14₁ du transistor 14, l'antenne 18 transmet des signaux alternatifs dont l'amplitude croît à partir de 0. C'est seulement à partir d'un seuil d'amplitude que ce signal est exploitable en réception. Ainsi, le temps de montée du signal limite également la vitesse de transmission en tout ou rien. De façon analogue, à la disparition des créneaux appliqués sur l'électrode 14₁, les signaux transmis présentent également une amplitude décroissante. Ces signaux ne sont pas détectables lorsque l'amplitude descend au-dessous d'un seuil. Ainsi, la durée de transmission des signaux d'amplitude inférieure à ce dernier seuil ne constitue pas une transmission d'informations exploitables et elle limite donc aussi la vitesse de transmission.

L'invention a pour but de remédier à au moins certains des inconvénients mentionnés ci-dessus.

Le dispositif d'émission d'informations installé à bord d'un véhicule et alimenté par une batterie d'accumulateurs conforme à l'invention comprend, en série avec un interrupteur commandé tel qu'un transistor, une inductance d'émission qui acquiert de l'énergie de la batterie quand l'interrupteur est conducteur et qui transmet son énergie à un condensateur quand l'interrupteur est ouvert, la résistance de ce circuit à inductance et condensateur étant négligeable.

Dans ces conditions, l'inductance peut constituer l'antenne d'émission, ce qui simplifie le montage.

Dans le mode de réalisation préféré de l'invention, l'inductance, dite primaire, est associée à une autre inductance, dite secondaire, de façon à constituer un transformateur ou un auto-transformateur, l'énergie accumulée dans l'inductance primaire se déchargeant dans l'inductance secondaire et le condensateur lorsque l'interrupteur est ouvert.

Dans ce cas, c'est tant l'inductance primaire que l'inductance secondaire qui constitue l'émetteur. L'intensité du courant émis est particulièrement élevée, ce qui permet, par rapport au circuit connu représenté sur la figure 1, une puissance d'émission plus élevée pour une même énergie fournie par la batterie, l'adaptation d'impédance étant améliorée.

En outre, avec un tel dispositif comportant un circuit d'émission tel qu'un moyen inductif d'émission se trouve, d'une part, dans un montage à oscillation forcée quand un signal périodique à deux états à transmettre présente un premier état et, d'autre part, dans un montage à oscillation libre, quand le signal périodique présente le second état, la transmission est plus rapide tant en modulation de fréquence qu'en modulation d'amplitude.

En effet, quand les informations sont transmises par modulation de fréquence des créneaux de commande de l'interrupteur, il ne se produit pas d'atténuation de l'amplitude du signal émis lors de ce changement de fréquence. Dans ces conditions, la fréquence de transmission des informations peut être plus élevée. Cependant, pour obtenir une absence complète d'atténuation d'amplitude lors d'un changement de fréquence, il est nécessaire que la période du dernier créneau à la première fréquence et la période du premier créneau à la seconde fréquence soient des périodes complètes et non des fractions de périodes.

Lors d'une transmission par modulation d'amplitude des créneaux de commande de l'interrupteur, le temps de montée de l'énergie dans l'inductance est réduit, de l'ordre d'un quart de la période des fréquences des créneaux.

On peut aussi, lors de la disparition d'un train de commande, limiter le temps de descente des signaux émis en prévoyant une résistance de dissipation associée à un autre interrupteur commandé qui court-circuite cette résistance en dehors des périodes de fin de transmission d'un train de créneaux

Quel que soit le mode de réalisation de l'invention, la résistance de dissipation en série avec l'inductance ou les inductances et le condensateur étant faible ou nulle, le signal émis présente la forme d'une sinusoïde pratiquement symétrique, ce qui limite le taux des harmoniques de rang 2 et de rang supérieur qui sont émises.

Dans le cas où l'inductance primaire et l'inductance secondaire sont constituées par deux inductances en série, chacune des inductances étant formée par des spires, si l'on désire modifier les conditions d'émission du dispositif, il suffit de modifier la position de ce point de jonction, c'est-à-dire, par exemple, d'augmenter le nombre de spires de l'enroulement primaire et de diminuer corrélativement le nombre de spires de l'enroulement secondaire.

Les spires peuvent être des fils reliés les uns aux autres par l'intermédiaire d'une plaquette du type circuit imprimé. Dans ce cas, le point de connexion peut être modifié aisément sur la plaquette.

Dans un mode de réalisation, on utilise un même ensemble de spires et un même condensateur pour deux dispositifs d'émission distincts présentant chacun son propre interrupteur. Dans ce cas, les points de jonction entre inductances primaire et secondaire des deux dispositifs peuvent être distincts. On peut aussi réaliser un dispositif à puissance d'émission variable.

Dans un autre mode de réalisation, l'inductance primaire et l'inductance secondaire constituent, respectivement, le primaire et le secondaire d'un transformateur, le condensateur du circuit oscillant étant prévu aux bornes du secondaire.

Ainsi, l'invention concerne, de façon générale, un dispositif d'émission d'informations d'un véhicule vers un objet portatif se trouvant à proximité du véhicule, ce dispositif comprenant un moyen inductif d'émission et les informations à transmettre étant constituées par des signaux périodiques à deux états. Ce dispositif comporte un circuit d'émission tel que le moyen inductif se trouve dans un montage à oscillation forcée quand le signal périodique présente un premier état et dans un montage à oscillation libre quand le signal périodique présente le second état.

Dans une réalisation, le moyen inductif comporte une inductance primaire et une inductance secondaire en série, l'inductance primaire étant seule chargée en énergie, c'est-à-dire en oscillation forcée, quand le signal périodique présente le premier état, l'ensemble de l'inductance secondaire et de l'inductance primaire en série se trouvant dans le montage à oscillation libre quand le signal périodique présente le second état.

Selon une autre réalisation, le moyen inductif comprend, d'une part, une inductance primaire disposée dans le montage à oscillation forcée quand le signal périodique présente le premier état et, d'autre part, une inductance secondaire, couplée à l'inductance primaire, qui est disposée dans le montage à oscillation libre lorsque le signal périodique présente le second état.

Les signaux périodiques à transmettre peuvent rendre alternativement conducteur et bloqué (ouvert) un interrupteur commandé, tel qu'un transistor, cet interrupteur étant disposé de façon telle, que lorsqu'il est conducteur, l'inductance primaire se trouve dans le montage à oscillation forcée et lorsque l'interrupteur est bloqué (ouvert), l'inductance primaire et l'inductance secondaire, ou l'inductance secondaire, se trouve(nt) dans le montage à oscillation libre.

Les signaux périodiques sont par exemple des créneaux présentant au moins deux fréquences différentes. Dans ce cas, le dispositif peut comporter des moyens pour que, lors de la transition d'émission d'une première fréquence vers une seconde fréquence, la dernière période (T₁) à la première fréquence soit entière et, de même, la première période (T₂) à la seconde fréquence (f₂) soit également entière.

Au moins certaines informations à transmettre peuvent être du type tout ou rien, un premier type d'information correspondant à un train de signaux périodiques et un second type d'informations correspondant à une absence de train de signaux périodiques.

Les signaux périodiques peuvent appartenir au groupe comprenant : les signaux analogiques à modulation de fréquence, les signaux numériques à modulation de fréquence, et les signaux à modulation à amplitude constante telle que la modulation de phase.

Dans une réalisation, le dispositif comporte, dans le montage à oscillation libre, une résistance d'amortissement qui est mise en circuit pour dissiper l'énergie emmagasinée dans le circuit à oscillation libre à la fin d'une émission d'un train de signaux périodiques.

Si on fait appel à un moyen inductif à inductances primaire et secondaire en série, ce moyen peut être utilisé pour constituer deux jeux d'inductances en série, ces jeux étant utilisés pour l'émission de signaux différents.

Les deux jeux d'inductances peuvent être utilisés pour l'émission de signaux à modulation d'amplitude à un niveau différent.

Ils peuvent aussi être utilisés pour l'émission de signaux à phases différentes, notamment à phases inversées, et/ou pour émettre des signaux ayant des portées différentes et/ou des signaux de natures différentes.

D'autres caractéristiques et avantages de l'invention apparaîtront avec la description de certains de ses modes de réalisation, celle-ci étant effectuée en se référant aux dessins ci-annexés sur lesquels :
la figure 1, déjà décrite, est un dispositif émetteur à bord d'un véhicule conforme à l'état antérieur de la technique,
la figure 2 est un schéma de principe d'un premier mode de réalisation de dispositif d'émission conforme à l'invention,
la figure 3 montre une variante du dispositif représenté sur la figure 2,
la figure 4 est un schéma d'un détail de réalisation utilisable avec le dispositif représenté sur les figures 2 et 3,
la figure 5 est un diagramme montrant un aspect du fonctionnement du dispositif représenté sur la figure 2,
la figure 6 est un diagramme montrant un autre mode de fonctionnement du dispositif représenté sur la figure 2, et
la figure 7 montre une variante du dispositif représenté sur la figure 2.
la figure 8 montre une autre variante du dispositif selon l'invention.

Le dispositif d'émission représenté sur la figure 2 est un dispositif destiné à transmettre des informations d'un véhicule (non montré) vers un objet portatif (également non montré) tel qu'un badge de format carte de crédit, détenu par l'usager du véhicule. Ce dispositif émetteur présente une portée limitée, de l'ordre de quelques mètres. Il est destiné, comme décrit ci-dessus en relation avec la figure 1, à émettre un signal vers l'objet portatif. Ce signal est, par exemple, constitué par un signal destiné à activer l'objet portatif afin qu'il émette un signal en retour. Le signal du badge est alors reçu par un circuit récepteur (non montré) dans le véhicule. Si le badge émet un signal reconnu par un récepteur du véhicule, l'émetteur envoie un signal d'interrogation auquel le badge répond en envoyant son signal d'identification. Si ce signal correspond au véhicule, alors les portières sont déverrouillées. En outre, le badge peut avoir une fonction analogue à celle d'une clé de contact.

Le dispositif émetteur représenté sur la figure 2 comporte, comme celui représenté sur la figure 1, un transistor 30, par exemple de type MOS, sur l'électrode de commande 31 duquel sont appliqués des signaux rectangulaires. Une borne de ce transistor interrupteur 30 est reliée à la masse tandis que son autre borne est reliée à un point de connexion 32 entre une inductance primaire 34 et une inductance secondaire 36. Les inductances 34 et 36 sont constituées par des spires en série. La borne de l'inductance 34 qui est opposée à la borne 32 de jonction au transistor 30 est reliée à une borne 38 d'un accumulateur dont l'autre borne est connectée à la masse.

En outre, aux bornes de l'ensemble des deux inductances 34 et 36 en série, est disposé un condensateur 40.

Le fonctionnement de ce dispositif est le suivant : sur la grille 31 du transistor 30, on applique des signaux carrés ayant, dans l'exemple, une fréquence de l'ordre de 125 KHz. Quand le signal carré est au niveau haut, le transistor 30 est conducteur et dans ces conditions, l'inductance 34 emmagasine de l'énergie fournie par la batterie. Quand le signal carré appliqué sur l'électrode 31 est au niveau bas, l'énergie emmagasinée dans l'inductance 34 se décharge dans l'inductance secondaire 36 et dans le condensateur 40.

Les inductances primaires et secondaires 34 et 36 constituent des bobines émettrices. Le circuit d'inductances 34, 36, et condensateur 40 est du type à oscillation libre. Il émet un signal sinusoïdal 42 (figure 2a). La demi-période positive de cette sinusoïde 42 correspond à la période de conduction du transistor 30 tandis que la demi-période négative 46 correspond au blocage du transistor. Dans le premier cas (transistor 30 conducteur), l'oscillation est forcée; dans le cas du blocage du transistor, l'oscillation est libre.

Pour une gamme déterminée de fréquences de commande de la conduction du transistor 30, et à condition que les valeurs des inductances et du condensateur soient correctement choisies, les signaux émis gardent la forme d'une sinusoïde symétrique quelle que soit la fréquence dans la gamme choisie, la qualité de cette symétrie dépendant du coefficient de qualité du circuit, c'est-à-dire de sa résistance de perte. Dans ces conditions, l'émission des harmoniques de rang 2 est faible, ce qui constitue un filtrage si ces harmoniques se trouvent dans un domaine de fréquences dont l'émission n'est pas autorisée.

Les propriétés d'apériodicité du circuit, c'est-à-dire l'indépendance (relative) à l'égard de la fréquence, entraînent que, lorsque la fréquence des signaux carrés appliqués sur l'électrode 31 est modifiée, il n'y a pratiquement pas d'atténuation de l'amplitude de l'onde émise. Cependant, pour obtenir cette propriété, il est nécessaire que, lorsqu'on passe d'une fréquence f₁ (représentant par exemple un "0") à une fréquence f₂ (représentant par exemple un "1"), c'est-à-dire d'une période T₁ à une période T₂, les signaux carrés présentent des périodes entières. Autrement dit, comme représenté sur le diagramme de la figure 5, il faut que la dernière période T₁ des signaux à la fréquence f₁ soit complète et que la première période T₂ des signaux à la seconde fréquence f₂ soit également complète.

Ainsi, quand les signaux carrés sont modulés en fréquence, il n'y a pas d'atténuation d'amplitude lors d'une transition d'une fréquence f₁ à une autre fréquence f₂, ce qui permet, comme indiqué ci-dessus, d'augmenter la vitesse de transmission. L'absence d'atténuation d'amplitude lors d'une transition résulte du fait qu'à chaque période, la première oscillation est forcée.

Pour la même raison, lorsque les informations sont transmises par tout ou rien, c'est-à-dire lorsqu'un train de créneaux représente un "1" et une absence de signal sur la grille représente un "0" (ou vice-versa), le temps de montée du signal émis correspond à un quart de sinusoïde, c'est-à-dire à un quart de la période, soit pour une fréquence de l'ordre de 125 KHz, une durée de 2 µs. Toutes choses restant égales par ailleurs avec un dispositif du type de celui représenté sur la figure 1, ce temps de montée est d'autant plus grand que le coefficient de qualité est grand, comme c'est le cas quand on veut fortement atténuer les harmoniques. Ainsi, avec l'invention, la transmission des signaux par tout ou rien peut être plus rapide tout en permettant une atténuation rapide des harmoniques.

Il est à noter, comme montré sur la figure 6, qu'un tel signal en tout ou rien présente une période de coupure 50 dont la plus grande partie est indisponible pour la réception puisqu'elle correspond à un signal émis dont l'amplitude descend au-dessous d'un seuil de réception. Mais cette période 50 existe tant pour le circuit classique que pour le circuit conforme à l'invention.

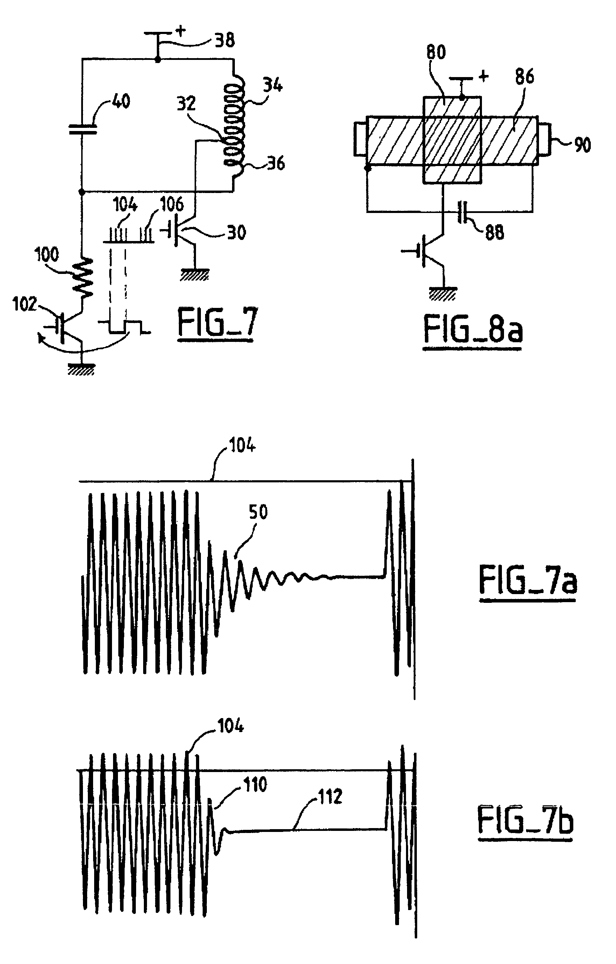

Cependant, dans le mode de réalisation montré sur la figure 7, cette période 50 est réduite ou supprimée en prévoyant une résistance 100 de dissipation en série avec un autre interrupteur 102 tel qu'un transistor. L'ensemble en série de la résistance 100 et du transistor 102 est disposé entre le condensateur 40, à l'opposé de la borne d'alimentation 38, et la masse. Le transistor 102 est rendu conducteur entre deux trains d'impulsion 104 et 106. Ainsi, quand le signal en tout ou rien est nul, la résistance 100 absorbe l'énergie restante dans le condensateur 40. L'effet apporté par cette disposition est montré en comparant les figures 7a et 7b. La figure 7a montre les oscillations 50 à la fin d'un train 104 d'impulsions quand ni la résistance 100, ni le transistor 102 ne sont prévus alors que la figure 7b montre que la période de transition 100 entre un train d'impulsion 104 et une absence 112 d'impulsion est beaucoup plus courte quand on prévoit la résistance 100 et le transistor 102.

Dans un exemple, la valeur de la résistance 100 est de 100 ohms.

Dans un mode de réalisation, les spires des inductances 34 et 36 sont constituées par une nappe de fils, formant par exemple un ruban, chaque spire étant, par exemple, de forme rectangulaire et enrobée dans la paroi de toit du véhicule.

Les spires sont, de préférence, associées comme représenté sur la figure 4 à l'aide d'une plaquette 52 de type circuit imprimé. La plaquette 52 qui, dans l'exemple, est de forme rectangulaire, présente des bornes sur chacun des grands côtés du rectangle, à savoir, dans cet exemple, quatre bornes 52₁ à 52₄ sur la gauche et quatre bornes 52₅ à 52₈ sur la droite. L'inductance primaire comporte une spire constituée par un fil 54 dont la première extrémité est reliée à la borne 52₁ et la seconde extrémité à la borne 52₆.

L'inductance secondaire est constituée par des fils 56 et 58 en série entre eux et en série avec le fil 54. A cet effet, la plaquette 52 comporte une jonction conductrice 52₁₀ entre les bornes 52₆ et 52₂, et le fil 56 est connecté à la borne 52₂ et, de l'autre côté, à la borne 52₇. Une autre jonction conductrice 52₁₁ de la plaquette 52 relie la borne 52₇ à la borne 52₃, et le fil 58 est connecté, d'un côté, à la borne 52₃ et, de l'autre, à la borne 528.

Le transistor est connecté à la borne 52₂ ou 52₆ à la jonction entre l'inductance primaire et l'inductance secondaire. La batterie est reliée à la borne 52₁ tandis que le condensateur est relié entre les bornes 52₁ et 52₈.

On voit qu'avec une telle réalisation, on peut modifier aisément le rapport entre le nombre des spires des enroulements primaire et secondaire en choisissant le point de connexion du transistor sur la plaquette.

Dans une autre réalisation, qui est représentée sur la figure 3, les mêmes spires en série sont utilisées pour réaliser deux types d'émetteurs. Dans l'exemple représenté, on prévoit un ensemble 62 de spires en série, un condensateur 40 en parallèle sur l'ensemble de ces spires, un premier transistor 64 d'un premier dispositif émetteur est relié à un premier point de jonction 66 et un second transistor 68 est relié à un second point de jonction 70. On voit ainsi que les deux dispositifs d'émission à transistors, respectivement 64 et 68, présentent des rapports entre spires primaires et spires secondaires qui sont différents.

Ces deux dispositifs d'émission présentant des inductances communes et un condensateur commun peuvent, par exemple, être utilisés pour transmettre des signaux vers deux types de badges différents. Dans un mode de réalisation, c'est le transistor 64 qui est utilisé quand le véhicule est associé à un premier type d'objet portatif et c'est le transistor 68 qui est utilisé quand on fait appel à un second type d'objet portatif. En variante, les transistors 64 et 68 sont alimentés en permanence mais de façon alternée de façon, par exemple, à émettre vers deux badges présentant des degrés d'autorisation différents.

Les points de connexion 66 et 70 peuvent être disposés de façon symétrique par rapport aux extrémités de l'inductance 62. Dans ce cas, on peut utiliser les deux interrupteurs 64 et 68 pour transmettre des signaux à modulation d'amplitude à trois niveaux tels que le niveau 0 (sans transmission), le niveau 0,5 et le niveau 1.

Il est également possible de transmettre des signaux à amplitude constante à modulation de phase dans lesquels les phases des signaux appliquées aux transistors 64 et 68 peuvent être inversées. Dans ce cas, l'alimentation doit être connectée entre les points 66 et 70.

Dans la variante représentée sur la figure 8, on prévoit une inductance primaire 80 reliée, d'un côté, au pôle positif 82 d'une batterie et, de l'autre, à la masse par l'intermédiaire du transistor de commande 84 sur la grille duquel sont appliqués les signaux carrés de commande. Ce dispositif comprend, en outre, un enroulement secondaire 86 aux bornes duquel est disposé un condensateur 88.

Les enroulements 84 et 86 sont enroulés sur un même noyau ferromagnétique 90 (figure 8a). Ainsi, l'enroulement 80 constitue le primaire d'un transformateur dont le secondaire est l'enroulement 86.

Le fonctionnement du dispositif représenté sur les figures 8 et 8a est analogue à celui du dispositif représenté sur la figure 2.

## Revendications

1. Dispositif d'émission d'informations d'un véhicule vers un objet portatif se trouvant à proximité du véhicule, ce dispositif comprenant un interrupteur (30, 64, 84), un condensateur (40, 88) et un moyen inductif (34, 36, 62, 80, 86) formant antenne d'émission, ledit moyen inductif (34, 36, 62, 80, 86) comportant une inductance primaire (34, 62, 80) et une inductance secondaire (36, 70, 86), les informations à transmettre étant constituées par des signaux périodiques à deux états,
**caractérisé en ce que** l'interrupteur (30, 64, 84) est disposé de façon telle que, lorsqu'il est conducteur, l'inductance primaire (34, 62, 80) se trouve dans un montage à oscillation forcée et lorsque l'interrupteur (30, 64, 84) est bloqué, l'inductance primaire (34, 62, 80) et l'inductance secondaire (36, 70, 86), ou l'inductance secondaire (36, 70, 86), se trouve(nt) dans le montage à oscillation libre.

2. Dispositif selon la revendication 1, **caractérisé en ce que** le condensateur (40, 88) est monté en parallèle avec l'inductance secondaire (36, 70, 86) ou les inductances primaire (34, 62, 80) et secondaire (36, 70, 86) afin de générer les oscillations libres.

3. Dispositif selon la revendication 1 ou 2, **caractérisé en ce** les inductances primaire (34) et secondaire (36) sont en série, l'ensemble de l'inductance secondaire (36) et de l'inductance primaire (34) en série se trouvant dans le montage à oscillation libre quand le signal périodique présente le second état.

4. Dispositif selon la revendication 1 ou 2, **caractérisé en ce que** l'une inductance primaire (80) est disposée dans le montage à oscillation forcée quand le signal périodique présente le premier état et l'inductance secondaire (86) est couplée à l'inductance primaire, ladite inductance secondaire (86) étant disposée dans le montage à oscillation libre lorsque le signal périodique présente le second état.

5. Dispositif selon l'une quelconque des revendications précédentes, **caractérisé en ce que** les signaux périodiques sont des créneaux présentant au moins deux fréquences différentes.

6. Dispositif selon la revendication 5, **caractérisé en ce qu'**il comporte des moyens pour que, lors de la transition d'émission d'une première fréquence vers une seconde fréquence, la dernière période (T₁) à la première fréquence soit entière et, de même, la première période (T₂) à la seconde fréquence (f₂) soit également entière.

7. Dispositif selon l'une quelconque des revendications précédentes, **caractérisé en ce qu'**au moins certaines informations à transmettre sont du type tout ou rien, un premier type d'information correspondant à un train de signaux périodiques, un second type d'informations correspondant à une absence de train de signaux périodiques.

8. Dispositif selon l'une quelconque des revendications précédentes, **caractérisé en ce que** les signaux périodiques appartiennent au groupe comprenant : les signaux analogiques à modulation de fréquence, les signaux numériques à modulation de fréquence, et les signaux à modulation à amplitude constante telle que la modulation de phase.

9. Dispositif selon l'une quelconque des revendications précédentes, **caractérisé en ce qu'**il comporte, dans le montage à oscillation libre, une résistance d'amortissement (100) qui est mise en circuit pour dissiper l'énergie emmagasinée dans le circuit à oscillation libre à la fin d'une émission d'un train de signaux périodiques.

10. Dispositif selon la revendication 3, **caractérisé en ce que** le moyen inductif (62) à inductances primaire et secondaire en série est utilisé pour constituer deux jeux d'inductances en série, ces jeux étant utilisés pour l'émission de signaux différents.

11. Dispositif selon la revendication 10, **caractérisé en ce que** les deux jeux d'inductances sont utilisés pour l'émission de signaux à modulation d'amplitude à un niveau différent.

12. Dispositif selon la revendication 10, **caractérisé en ce que** les deux jeux d'inductances sont utilisés pour l'émission de signaux à phases différentes, notamment à phases inversées.

13. Dispositif selon la revendication 10, **caractérisé en ce que** les deux jeux d'inductances sont utilisés pour émettre des signaux ayant des portées différentes et/ou des signaux de natures différentes.

## Claims

1. Device for emitting information from a vehicle to a portable object close to the vehicle, this device comprising a switch (30, 64, 84), a capacitor (40, 88) and an inductive means (34, 36, 62, 80, 86) forming an emission antenna, the said inductive means (34, 36, 62, 80, 86) comprising a primary inductance (34, 62, 80) and a secondary inductance (36, 70, 86), the information to be transmitted consisting of periodic signals with two states,
**characterised in that** the switch (30, 64, 84) is arranged such that when it is conducting, the primary inductance (34, 62, 80) is located in a circuit with forced oscillation, and when the switch (30, 64, 84) is not conducting, the primary inductance (34, 62, 80) and the secondary inductance (36, 70, 86), or the secondary inductance are in the free oscillation circuit.

2. Device according to claim 1, **characterised in that** the capacitor (40, 88) is installed in parallel with the secondary inductance (36, 70, 86) or the primary inductance (34, 62, 80) and the secondary inductance (36, 70, 86) so as to generate free oscillations.

3. Device according to claim 1 or 2, **characterised in that** the primary inductance (34) and the secondary inductance (36) are in series, the secondary inductance (36) and the primary inductance (34) in series being in the free oscillation circuit when the periodic signal is in the second state.

4. Device according to claim 1 or 2, **characterised in that** one primary inductance (80) is installed in the forced oscillation circuit when the periodic signal is in the first state and the secondary inductance (86) is coupled to the primary inductance, the said secondary inductance (86) being in the free oscillation circuit when the periodic signal is in the second state.

5. Device according to any one of the above claims, **characterised in that** the periodic signals are square pulses with at least two different frequencies.

6. Device according to claim 5, **characterised in that** it comprises means so that during the transition of emission from a first frequency to a second frequency, the last period (T₁) at the first frequency is complete, and similarly the first period (T₂) at the second frequency (f2) is also complete.

7. Device according to any one of the above claims, **characterised in that** at least some of the information to be transmitted is digital, a first type of information corresponding to a stream of periodic signals, a second type of information corresponding to a lack of a stream of periodic signals.

8. Device according to any one of the above claims, **characterised in that** the periodic signals form part of the group including analogue signals with frequency modulation, digital signals with frequency modulation and signals with constant amplitude modulation such as phase modulation.

9. Device according to any one of the above claims, **characterised in that** in the free oscillation circuit, it comprises a damping resistor (100) in a circuit to dissipate the energy stored in the free oscillation circuit at the end of emission of a stream of periodic signals.

10. Device according to claim 3, **characterised in that** the inductive means (62) with primary and secondary inductances in series is used to build up two sets of inductances in series, these sets being used for the emission of different signals.

11. Device according to claim 10, **characterised in that** the two sets of inductances are used for the emission of signals with different levels of amplitude modulation.

12. Device according claim 10, **characterised in that** the two sets of inductances are used for the emission of signals with different phases, and particularly inverted phases.

13. Device according to claim 10, **characterised in that** the two sets of inductances are used to emit signals with different ranges and / or different natures of signals.

## Patentansprüche

1. Vorrichtung zum Senden von Informationen von einem Fahrzeug zu einem tragbaren Objekt, das sich in der Nähe des Fahrzeugs befindet, wobei diese Vorrichtung einen Schalter (30, 64, 84), einen Kondensator (40, 88) und ein eine Sendeantenne bildendes induktives Mittel (34, 36, 62, 80, 86) enthält, wobei das induktive Mittel (34, 36, 62, 80, 86) eine primäre Induktivität (34, 62, 80) und eine sekundäre Induktivität (36, 70, 86) enthält, wobei die zu übertragenden Informationen aus periodischen Signalen mit zwei Zuständen bestehen,
**dadurch gekennzeichnet, dass** der Schalter (30, 64, 84) derart angeordnet ist, dass dann, wenn er geschlossen ist, die primäre Induktivität (34, 62, 80) sich in einer Schaltung mit erzwungener Schwingung befindet, und dann, wenn der Schalter (30, 64, 84) offen ist, die primäre Induktivität (34, 62, 80) und die sekundäre Induktivität (36, 70, 86) bzw. die sekundäre Induktivität (36, 70, 86) sich in frei schwingender Schaltung befinden bzw. befindet,

2. Vorrichtung nach Anspruch 1, **dadurch gekennzeichnet, dass** der Kondensator (40, 88) parallel mit der sekundären Induktivität (36, 70, 86) bzw. mit der primären Induktivität (34, 62, 80) und der sekundären Induktivität (36, 70, 86) geschaltet ist, um die freien Schwingungen zu erzeugen.

3. Vorrichtung nach Anspruch 1 oder 2, **dadurch gekennzeichnet, dass** die primäre Induktivität (34) und die sekundäre Induktivität (36) in Reihe geschaltet sind, wobei die in Reihe geschaltete Einheit aus sekundärer Induktivität (36) und primärer Induktivität (34) sich in frei schwingender Schaltung befindet, wenn das periodische Signal den zweiten Zustand aufweist.

4. Vorrichtung nach Anspruch 1 oder 2, **dadurch gekennzeichnet, dass** die eine primäre Induktivität (80) in der Schaltung mit erzwungener Schwingung angeordnet ist, wenn das periodische Signal den ersten Zustand aufweist und die sekundäre Induktivität (86) an die primäre Induktivität gekoppelt ist, wobei die sekundäre Induktivität (86) in frei schwingender Schaltung angeordnet ist, wenn das periodische Signal den zweiten Zustand aufweist.

5. Vorrichtung nach einem der vorangehenden Ansprüche, **dadurch gekennzeichnet, dass** die periodischen Signale Rechtecksignale sind, die zumindest zwei unterschiedliche Frequenzen aufweisen.

6. Vorrichtung nach Anspruch 5, **dadurch gekennzeichnet, dass** sie Mittel enthält, damit beim Sendeübergang von einer ersten Frequenz zu einer zweiten Frequenz die letzte Periode (T₁) bei der ersten Frequenz ganz ist und ebenso die erste Periode (T₂) bei der zweiten Frequenz (f2) auch ganz ist.

7. Vorrichtung nach einem der vorangehenden Ansprüche, **dadurch gekennzeichnet, dass** zumindest bestimmte zu übertragende Informationen vom Typ alles oder nichts sind, wobei eine erste Art von Informationen einer Folge von periodischen Signalen entspricht und eine zweite Art von Informationen einer fehlenden Folge von periodischen Signalen entspricht.

8. Vorrichtung nach einem der vorangehenden Ansprüche, **dadurch gekennzeichnet, dass** die periodischen Signale zur Gruppe gehören, die frequenzmodulierte Analogsignale, frequenzmodulierte Digitalsignale und modulierte Signale konstanter Amplitude, wie phasenmodulierte Signale enthält.

9. Vorrichtung nach einem der vorangehenden Ansprüche, **dadurch gekennzeichnet, dass** sie bei frei schwingender Schaltung einen Dämpfungswiderstand (100) enthält, der zugeschaltet wird, um die in frei schwingender Schaltung eingespeicherte Energie am Ende der Ausgabe einer Folge von periodischen Signalen abzuführen.

10. Vorrichtung nach Anspruch 3, **dadurch gekennzeichnet, dass** das induktive Mittel (62) mit in Reihe geschalteter primärer und sekundärer Induktivität dazu verwendet wird, zwei Sätze von in Reihe geschalteten Induktivitäten zu bilden, wobei diese Sätze zum Ausgeben unterschiedlicher Signale verwendet werden.

11. Vorrichtung nach Anspruch 10, **dadurch gekennzeichnet, dass** die beiden Sätze von Induktivitäten zum Ausgeben von auf unterschiedlichem Pegel amplitudenmodulierten Signalen verwendet werden.

12. Vorrichtung nach Anspruch 10, **dadurch gekennzeichnet, dass** die beiden Sätze von Induktivitäten zum Ausgeben von Signalen mit unterschiedlichen Phasen, insbesondere mit umgekehrten Phasen verwendet werden.

13. Vorrichtung nach Anspruch 10, **dadurch gekennzeichnet, dass** die beiden Sätze von Induktivitäten zum Ausgeben von Signalen mit unterschiedlichen Reichweiten und/oder zum Ausgeben von ungleichartigen Signalen verwendet werden.
